# EUROPEAN PATENT SPECIFICATION

(11) **EP 2 073 213 B1**
(45) Date of publication and mention of the grant of the patent: **26.01.2011**
(21) Application number: 07150252.0
(22) Date of filing: 20.12.2007
(51) Int. Cl.: G11C 19/08, G11C 19/02, G11C 11/14

(54) **Data storage device using magnetic domain wall movement and method of operating the data storage device**
Datenspeichervorrichtung mit magnetischer Domänenwandbewegung und Betriebsverfahren für die Datenspeichervorrichtung
Dispositif de stockage de données utilisant un mouvement de paroi de domaine et procédé de fonctionnement du dispositif de stockage de données

(43) Date of publication of application: 24.06.2009
(60) Divisional application: 10191735.9
(73) Proprietor: Samsung Electronics Co., Ltd., Suwon-si Gyeonggi-do 443-742 (KR)
(72) Inventor: Kim, Yong-su, Gyeonggi-do (KR)
(74) Representative: Greene, Simon Kenneth

(56) References cited:
- EP-A- 1 826 771
- GB-A- 1 090 921
- GB-A- 2 207 312
- US-A- 3 369 225
- US-A1- 2006 238 191
- US-A1- 2008 080 234

## Description

### BACKGROUND OF THE INVENTION

Apparatuses and methods consistent with the present invention relate to a data storage device and a method of operating the data storage device, and more particularly, to a data storage device using magnetic domain wall movement of a magnetic material and a method of operating the data storage device.

A magnetic minute area included in a ferromagnetic body is referred to as a magnetic domain. The direction of a magnetic moment is identical in the magnetic domain. The size and magnetization direction of the magnetic domain can be appropriately controlled by the properties, shape and size of the magnetic material and an external energy applied to the magnetic material.

A magnetic domain wall is a boundary area between magnetic domains having different magnetization directions and has a predetermined volume. The magnetic domain wall can be moved by a magnetic field or current applied to the magnetic material. That is, a plurality of magnetic domains having particular magnetization directions can be formed in a magnetic layer having predetermined width and thickness and the magnetic domains can be moved using a magnetic field or current having an appropriate strength.

A magnetic domain wall movement principle can be applied to a data storage device. When the magnetic domain wall movement principle is applied to a data storage device, since the magnetic domain wall movement allows the magnetic domains to pass by a read/write head, read/write operations are possible without rotation or any physical movement of a recording medium. An example of the data storage device in which the magnetic domain wall movement principle is applied has been introduced by U.S. Patent No. 6,834,005 B1.

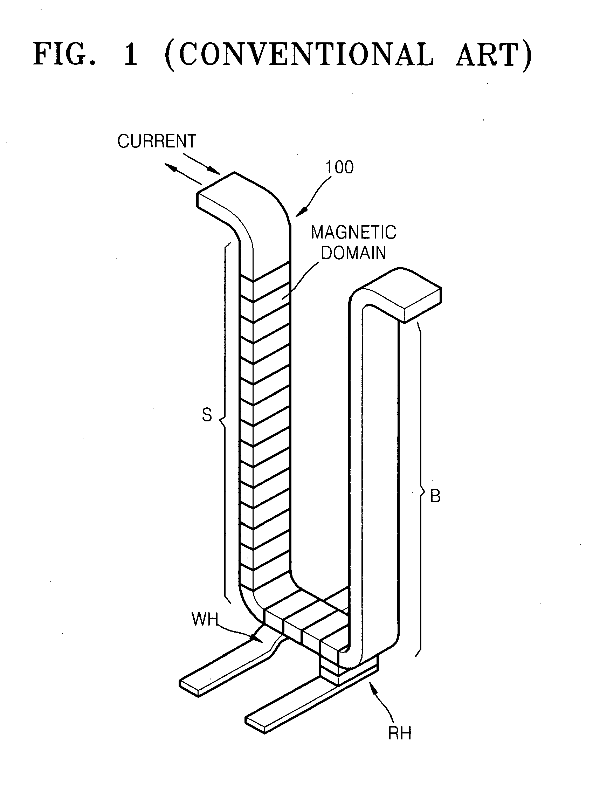

FIG. 1 is a perspective view of a conventional data storage device using the magnetic domain wall movement principle which was introduced in U.S. Patent No. 6,834,005 B1. Referring to FIG. 1, the conventional data storage device using the magnetic domain wall movement principle (hereinafter, referred to as "conventional storage device") includes a U-shaped magnetic layer 100. The magnetic layer 100 includes a storage area S formed of a plurality of magnetic domains that are arranged one after the other and a buffer area B having a length similar to that of the storage area S. In FIG. 1, the buffer area B is the right column part of the magnetic layer 100, but the position thereof may vary. A read head RH and a write head WH are provided under the middle portion of the magnetic layer 100.

Although it is not illustrated, the magnetic layer 100 is connected to a transistor used as a driving device. The direction of current applied to the magnetic layer 100 is controlled by the transistor. The direction of the magnetic domain wall movement is determined according to the direction of the current. The read/write operation is performed by pushing and pulling the magnetic domain walls by controlling the direction of the current.

However, the above-described conventional storage device has the following disadvantages.

First, since the conventional storage device, which performs the read/write operation by pushing and pulling the magnetic domain walls, requires the buffer area B to be as large as the storage area S, an effective storage capacity is only 1/2 of a physical storage capacity.

Second, when a read operation is performed by pushing the magnetic domain walls toward the buffer area B, for a next read operation, the magnetic domains of the buffer area B are pulled back toward the storage area S to return the position of the magnetic domains to their original state. Accordingly, power consumption increases and the read and write speed of data decreases.

Third, since the operation of pushing and pulling the magnetic domain walls is repeated, the characteristic of the magnetic domain wall is deteriorated and the life span of the storage device is shortened.

Fourth, since the U-shaped magnetic layer 100 is difficult to manufacture using present etching techniques, it is difficult to produce the conventional storage device. Furthermore, a plurality of notches need to be formed at regular intervals on the surface of the magnetic layer 100 to secure the stability of the magnetic domain wall movement. However, it is very difficult to uniformly form the fine notches on the U-shaped magnetic layer 100.

Therefore, the problems of the conventional storage device stem from the pushing and pulling of the magnetic domain walls and the U shape of the magnetic layer 100.

A shift register using a magnetic film is described in US 3,369,225. Data may be read at one end of the film and recirculated to the other.

EP 1 826 771 describes a magnetic memory using magnetic domain dragging in a linear magnetic layer.

### SUMMARY OF THE INVENTION

Exemplary embodiments of the present invention overcome the above disadvantages and other disadvantages not described above. Also, the present invention is not required to overcome the disadvantages described above, and an exemplary embodiment of the present invention may not overcome any of the problems described above. Accordingly, the present invention provides a data storage device using magnetic domain wall movement having a structure and an operational mode that may improve the effective storage capacity, power consumption, operational speed, life span, and realization thereof

The present invention also provides a method of operating the above data storage device.

According to the present invention there is provided a data storage device according to claim 1.

The write head may be a structure in which a first electrode, an anti-ferromagnetic layer, a ferromagnetic layer, a separation layer, the end portion of the magnetic layer, and a second electrode are sequentially deposited.

The data storage device may further comprise a separation layer between the magnetic layer and the write head.

The separation layer may comprise a conductive layer.

The read head may be a structure in which a first electrode, an anti-ferromagnetic layer, a first ferromagnetic layer, a separation layer, a second ferromagnetic layer, and a second electrode are sequentially deposited.

The data storage device may comprise a separation layer between the magnetic head and the read head.

The separation layer of the data storage device may comprise an insulation layer or a conductive layer.

An electric resistance of the conductive layer may be 10-100 times greater than that of the magnetic layer.

The data storage device may further comprise a driving device connected to the magnetic layer and which supplies energy which moves a wall between adjacent ones of the plurality of magnetic domains.

The magnetic layer may be a linear type Layer.

A plurality of notches may be formed on a surface of the magnetic layer.

The write head and the read head each may be provided to correspond to respective bit areas closed to each other.

The data storage device may further comprise a data controller connected to the stack memory. The write head and the read head may be a giant magneto resistance (GMR) head or a tunnel magneto resistance (TMR) head.

According to the present invention there is provided a method of operating a data storage device according to claim 11.

### BRIEF DESCRIPTION OF THE DRAWINGS

The above and other features and aspects of the present invention will become more apparent by describing in detail exemplary embodiments thereof with reference to the attached drawings in which:
FIG. 1 is a perspective view of a conventional data storage device using the magnetic domain wall movement principle which is introduced in U.S. Patent No. 6,834,005 B1;
FIG. 2 is a schematic cross-sectional view of a data storage device using a magnetic domain wall movement according to a comparative example;
FIGS. 3A through 3C are cross-sectional views for explaining a read operation of the data storage device of FIG. 2, according to a comparative example;
FIG. 4 is a schematic cross-sectional view of a data storage device using a magnetic domain wall movement according to another exemplary embodiment of the present invention; and
FIGS. 5A and 5B are cross-sectional views for explaining a read operation of the data storage device of FIG. 4, according to another exemplary embodiment of the present invention.

### DETAILED DESCRIPTION OF THE DRAWINGS

The present invention will now be described more fully with reference to the accompanying drawings, in which exemplary embodiments of the invention are shown. The thicknesses of the layers and regions illustrated in the drawings are exaggerated for clarity.

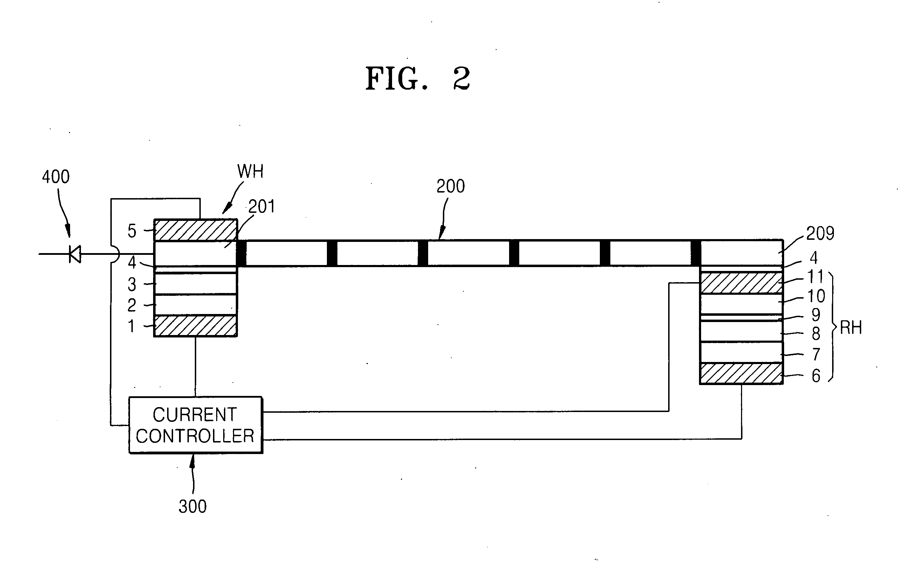

FIG. 2 is a cross-sectional view of a data storage device using magnetic domain wall movement according to a comparative example. Referring to FIG. 2, a data storage device (hereinafter, referred to as "first data storage device") includes a magnetic layer 200 having a plurality of magnetic domains. In FIG. 2, black portions in the magnetic layer 200 are magnetic domain walls that are boundaries between magnetic domains. The magnetic layer 200 may be of a linear type and notches may be formed on the surface of the magnetic layer 200 to improve stability of the magnetic domain wall movement. The notches may be formed to define magnetic domain areas. The entire area of the magnetic layer 200 may be employed as a storage area, as is described later. That is, the magnetic layer 200 may have no buffer area.

A write head (WH) is provided at an end portion 201 of the magnetic layer 200 and a read head (RH) may be provided at the other end portion 209 thereof. The WH and RH may each be a head using a giant magneto-resistance (GMR) effect or a tunnel magneto-resistance (TMR) effect.

In detail, the WH may be a structure in which a first electrode 1, a first anti-ferromagnetic layer 2, a first ferromagnetic layer 3, a first separation layer 4, the end portion 201 of the magnetic layer 200, and a second electrode 5 are sequentially deposited. When the first separation layer 4 is an insulation layer, the WH is a TMR head and when the first separation layer 4 is a conductive layer the WH head is a GMR head.

The first ferromagnetic layer 3 is a pinned layer in which the magnetization direction thereof is fixed by the first anti-ferromagnetic layer 2. The end portion 201 of the magnetic layer 200 is a free layer in which the magnetization direction is variable. The magnetization direction of the end portion 201 of the magnetic layer 200 is determined according to a voltage difference between the first electrode 1 and the second electrode 5.

When the first separation layer 4 is a conductive layer, the electric resistance of the first separation layer 4 may be greater than that of the magnetic layer 200. Thus, current leakage through the first separation layer 4 may be prevented. For the same reason, a conductive layer having a resistance greater than that of the magnetic layer 200 may be provided between the end portion 201 of the magnetic layer 200 and the second electrode 5. The electric resistance of the conductive layers may be 10 to 100 times greater than that of the magnetic layer 200.

The RH may be arranged at the other end portion 209 of the magnetic layer 200 and may be a structure in which a third electrode 6, a second anti-ferromagnetic layer 7, a second ferromagnetic layer (fixed layer) 8, a second separation layer 9, a third ferromagnetic layer (free layer) 10, and a fourth electrode 11 are sequentially deposited. When the second separation layer 9 is an insulation layer, the RH is a TMR head and when the second separation layer 9 is a conductive layer the RH is a GMR head. The RH and the magnetic layer 200 can be separated a predetermined distance from each other. Another separation layer 4 that is the same as the first separation layer 4 may be provided between the magnetic layer 200 and the RH, that is, on the lower surface of the other end portion 209 of the magnetic layer 200. The separation layer 4 may be an insulation layer to reduce noise generated during a read operation. The separation layer 4 may be provided on the entire area of the lower surface of the magnetic layer 200.

During the read operation, the principle that resistance between the electrodes 6 and 11 of the RH changes according to the magnetization direction of the other end portion 209 of the magnetic layer 200 is employed.

A current controller 300 is provided between the WH and RH and connected therebetween. The current controller 300 passes information obtained from the RH to the WH. Thus, a difference in the electric potential between the electrodes 1 and 5 of the WH may be determined by the information obtained from the RH. In other words, the data read from the other end portion 209 of the magnetic layer 200 may be transferred to the end portion 201 of the magnetic layer 200.

Also, the first data storage device may further include a driving device 400 connected to the end portion 201 of the magnetic layer 200. The driving device 400 for supplying current to move a magnetic domain wall may be a diode. Since the magnetic domain wall is moved in the same direction as a direction in which electrons move, the direction of the magnetic domain wall movement is opposite to the direction of current flow. The magnetic domain wall movement may alternatively be realized by an external magnetic field, instead of a current.

A method of operating the first storage device described with reference to FIG. 2 is described below.

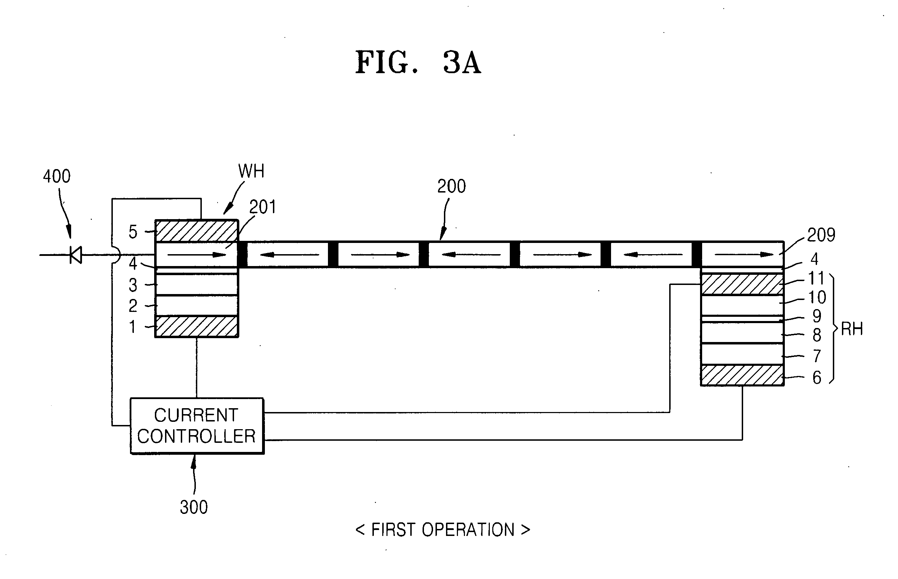

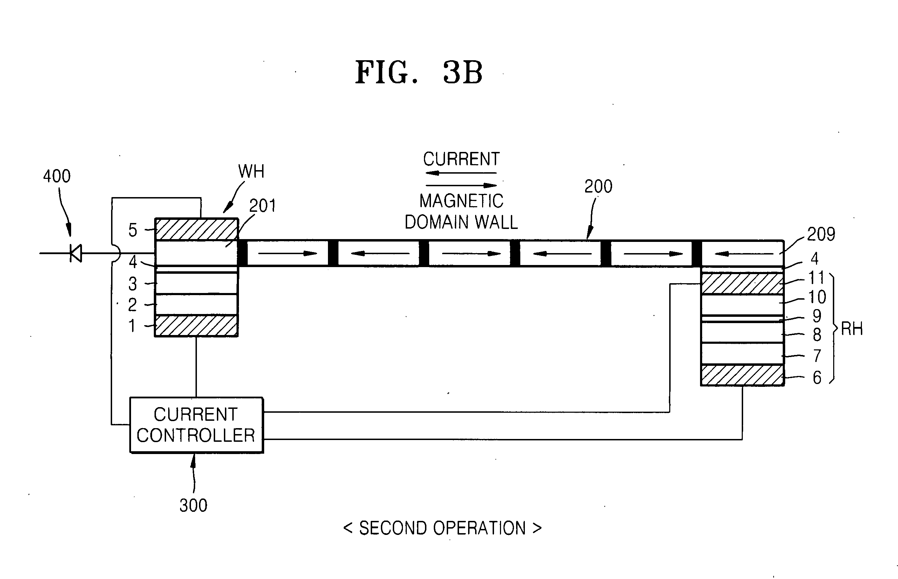

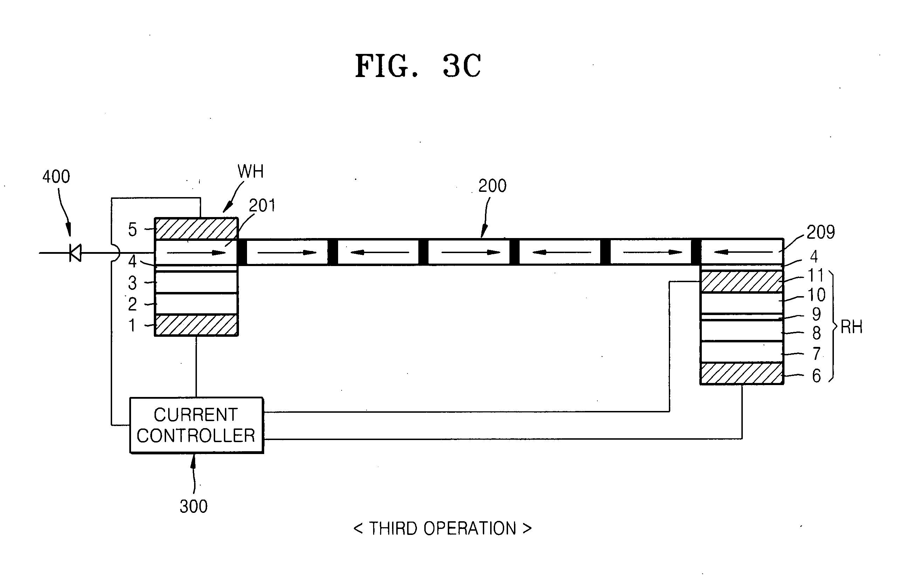

FIGS. 3A through 3C are views for explaining a read operation of the first data storage device. A method of operating the first data storage device includes reading information of the other end portion 209 of the magnetic layer 200 using the RH (operation 1), moving the magnetic domain walls of the magnetic layer 200 by one bit unit toward the other end portion 209 using the driving device 400 (operation 2), and writing the read information to the end portion 201 of the magnetic layer 200 using the current controller 300 and the WH (operation 3). FIGS. 3A, 3B, and 3C respectively correspond to operations 1,2, and 3.

In operation 2, current is supplied in a direction from the other end portion 209 to the end portion 201 making the magnetic domain walls move in the opposite direction. In operation 3, the current controller 300 transmits the information read by the RH to the WH. The operations 1, 2, and 3 may be sequentially repeated.

In the method of operating the first data storage device the information read from the other end portion 209 of the magnetic layer 200 is transferred unchanged to the end portion 201 of the magnetic layer 200. In the transfer process, the magnetic domain wall is moved a distance corresponding to the length of one magnetic domain (one magnetic domain is one bit) toward the other end portion 209 of the magnetic layer 200. By repeating the magnetic domain wall movement and the transfer process, the read operation may be completed by moving the magnetic domain walls in a direction. The order of the bits of data after the read operation is the same as the order of the bits of the data before the read operation.

Although FIGS. 3A through 3C illustrate a case that the magnetic layer 200 has a horizontal magnetic anisotropy, the present invention may be identically applied to a case that the magnetic layer 200 has a perpendicular magnetic anisotropy.

An operation to write new data to the first data storage device includes writing new data to the end portion 201 of the magnetic layer 200 using the write head WH (operation 1') and moving the magnetic domain walls of the magnetic layer 200 by one bit toward the other end portion 209 using the driving device 400 (operation 2'). The operations 1' and 2' may be sequentially performed.

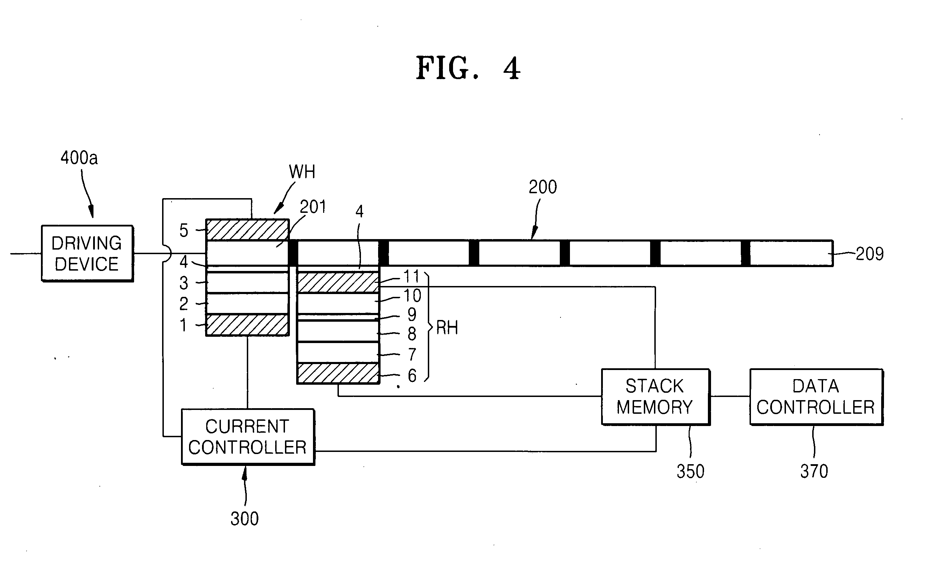

FIG. 4 is a cross-sectional view of a data storage device using a magnetic domain wall movement according to an embodiment of the present invention. In FIGS. 2 and 4, the same reference numerals indicate the same elements. Referring to FIG. 4, a data storage device using magnetic domain wall movement according to the present invention (hereinafter, referred to as "second data storage device") is a modification of the first data storage device.

Essentially, the magnetic layer 200, the position and structure of the WH, the structure of the RH, the material of the first separation layer 4, and the current controller 300 in the second data storage device are the same as those of the first storage device. However, in the second data storage device the RH may be formed on the magnetic layer 200 close to the WH. That is, the RH and WH may be provided to respectively correspond to two magnetic domains close to the end portion 201 of the magnetic layer 200. A separation layer 4 formed of the same material as the first separation layer 4 may be provided between the read head RH and the magnetic layer 200.

In the second data storage device, a stack memory 350 capable of storing data may be provided between the RH and the current controller 300. A data controller 370 connected to the stack memory 350 may be further provided. The data controller 370 may change the order of data stored in the stack memory 350 or may store new data in the stack memory 350.

Also, a driving device 400a applying energy for the magnetic domain movement in the second data storage device is different from the first data storage device. In detail, the driving device 400 in the first data storage device may be a diode. The driving device 400 of FIG. 2 moves the magnetic domain wall in one direction only. However, the driving device 400a in the second data storage device may move the magnetic domain in either direction. For example, the driving device 400a may include first and second transistors and may be connected to one of either end of the magnetic layer 200. The direction of the current being applied is changed according to the on/off state of the first and second transistors. The driving device 400a may be variously modified, for example, the first and second transistors may be connected to both ends of the magnetic layer 200.

Referring to FIG. 4, a method of operating the second data storage device is described below. -

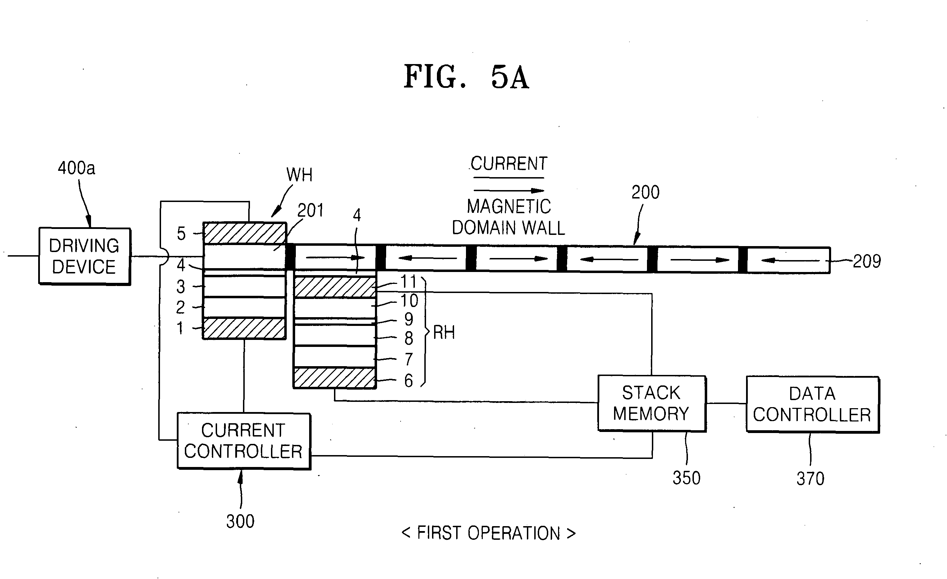

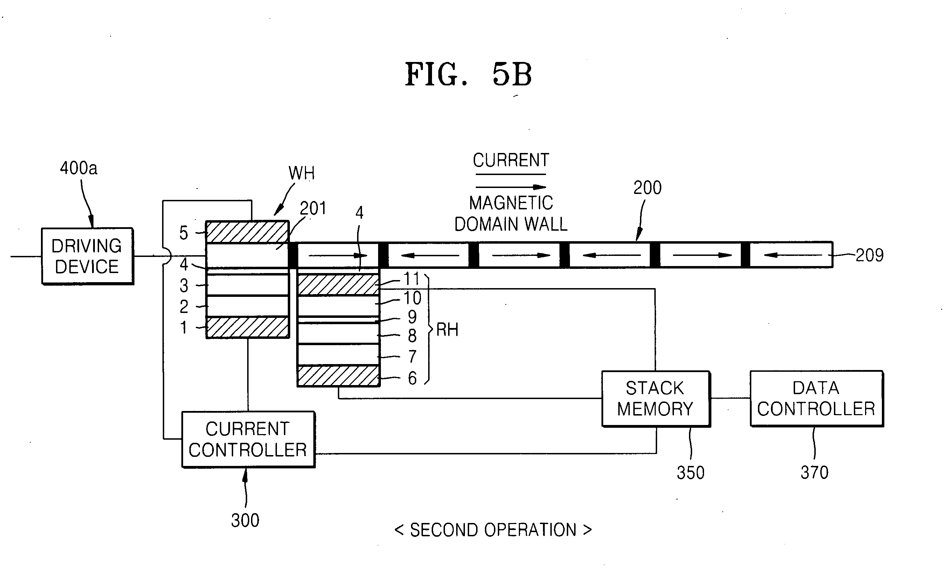

FIGS. 5A and 5B are views for explaining a read operation of the second data storage device. Referring to FIG. 5A, when data has been written to the magnetic layer 200, the data written to the magnetic layer 200 is read using the RH while moving the magnetic domain walls of the magnetic layer 200 toward the end portion 201 by one bit unit using the driving device 400a. The data read from the magnetic layer 200 may be stored in the stack memory 350. FIG. 5A shows a state in which current is applied to move the magnetic domain walls by one bit unit after the data of the portion of the magnetic layer 200 on the RH is read and stored in the stack memory 350.

Referring to FIG. 5B, while the magnetic domain walls of the magnetic layer 200 are moved using the driving device 400a by unit bit toward the other end portion 209, the data stored in the stack memory 350 is written to the magnetic layer 200 using the WH and the current controller 300. The order of output of data stored in the stack memory 350 is opposite to the input order. That is, the data input last needs to be output first. Although the stack memory 350 itself may include an input/output order related function, the data controller 370 connected to the stack memory 350 may include such a function. FIG. 5B shows that the magnetic domain walls are moved by one bit unit after the last bit of data of the stack memory 350 is written to the end portion 201 of the magnetic layer 200. The data written to the magnetic layer 200 returns to the state prior to the beginning of the read operation.

Referring to FIGS. 5A and 5B, it can be seen that the entire area of the magnetic layer 200 except for the end portion 201 of the magnetic layer 200 where the WH is located may be utilized as a data record area. Although FIGS. 5A and 5B illustrate a case where the magnetic layer 200 has a horizontal magnetic anisotropy, the present invention can be identically applied to a case where the magnetic layer 200 has a perpendicular magnetic anisotropy.

Although it is not illustrated, an operation to write new data to the second data storage device includes storing data in the stack memory 350 in a state where a read operation is not performed (operation 1") and writing the data stored in the stack memory 350 to the magnetic layer 200 using the WH and the current controller 300 while moving the magnetic domain walls of the magnetic layer 200 by one bit unit toward the other end portion 209 using the driving device 400a (operation 2"). In operation 1", data is stored in the stack memory 350 using the data controller 370.

In the second data storage device, the entire area of the magnetic layer 200 except for a portion of the magnetic layer 200 where the WH is located, that is, the end portion 201 of the magnetic layer 200, may be utilized as a data record area. That is, an effective storage capacity of the magnetic layer 200 is almost the same as the physical storage capacity. Although the stack memory 350 is additionally needed as a temporary archive of the data read from the magnetic layer 200, since the stack memory 350 is compact and can be commonly connected to a plurality of magnetic layers, the overall recording density of the data storage device is only slightly affected thereby.

As described above, in the data storage device according to an exemplary embodiment of the present invention, the effective storage capacity of the magnetic layer is the same as or substantially the same as the physical storage capacity. In particular, since the data at the other end portion of the magnetic layer is transferred to the end portion in the first data storage device, the read and write operation can be performed while the magnetic domain wall is moved in one direction only without a buffer area. Thus, the present invention may greatly increase the recording density of the data storage device using the magnetic domain wall movement.

Also, while in the conventional technology an operation is needed to restore the magnetic domains to the original position after reading, in the present invention, the operation which consumes power is not needed so that power consumption may be reduced and the data read and write speed may be increased. In addition, since the operation of pushing and pulling the magnetic domain walls is not repeated in the data storage device according to the exemplary embodiments of the present invention, the characteristic of the magnetic layer may be prevented from being deteriorated so that the life span of the device can be increased and reliability of the device is improved.

Furthermore, since the exemplary embodiment of the present invention uses a linear type magnetic layer, the manufacturing process may be simplified and high density and large capacity of the device may be made possible. In particular, when the driving device is formed on the lowermost layer and the magnetic layers connected to the driving device are formed in a multilayer structure, for example, a multilayer cross point architecture, high density and large capacity of the device can be easily achieved.

While this invention has been particularly shown and described with reference to exemplary embodiments thereof, it will be understood by those skilled in the art that various changes in form and details may be made therein without departing from the scope of the invention as defined by the appended claims.

## Claims

1. A data storage device using magnetic domain wall movement, the data storage device comprising:
a magnetic layer (200) having a plurality of magnetic domains;
a write head (WH) provided at an end portion (201) of the magnetic layer;
a read head (RH) to read data written to the magnetic layer,
a current controller (300) connected to the write head and the read head; and
a driving device (400,400a) connected to the magnetic layer, the driving device supplying current to the magnetic layer to move the plurality of magnetic domains and walls between two adjacent magnetic domains;
**characterised in that**
the read head is provided at a portion of the magnetic layer adjacent to the write head;
the plurality of magnetic domains extending further from the read head to an other end portion (209) of the magnetic layers;
the write head and the read head are each provided to correspond to respective bit areas that are adjacent to each other, and
further comprising a stack memory connected to the read head and the current controller.

2. The data storage device of any preceding claim, wherein the write head is a structure in which a first electrode (1), an anti-ferromagnetic layer (2), a ferromagnetic layer (3), a separation layer (4), the end portion of the magnetic layer (201), and a second electrode (5) are sequentially disposed.

3. The data storage device of claim 2, further comprising a separation layer between the magnetic layer and the write head.

4. The data storage device of claim 3, wherein the separation layer (4) is a conductive layer.

5. The data storage device of any preceding claim, wherein the read head (RH) is a structure in which a first electrode (6), an anti-ferromagnetic layer (7), a first ferromagnetic layer (8), a separation layer (9), a second ferromagnetic layer (10), and a second electrode (11) are sequentially deposited.

6. The data storage device of any preceding claim, further comprising a separation layer (4) between the magnetic layer (209) and the read head (RH).

7. The data storage device of claim 6, wherein the separation layer between the magnetic layer (209) and the read head (RH) is an insulation layer or a conductive layer.

8. The data storage device of claim 6, wherein the separation layer between the magnetic layer (209) and the read head (RH) is a conductive layer and an electric resistance of the conductive layer is 10-100 times greater than that of the magnetic layer.

9. The data storage device of any preceding claim, wherein the magnetic layer is a linear magnetic layer.

10. The data storage device of any preceding claim, wherein a plurality of notches are formed on a surface of the magnetic layer.

11. A method of operating a data storage device, the method comprising:
reading data written to a magnetic layer (200) having a plurality of magnetic domains using a read head (RH) provided at the magnetic layer, the read head being provided at a portion of the magnetic layer adjacent to a write head (WH) at one end portion (201) of the magnetic layer, the plurality of magnetic domains extending further from the read head to an other end portion (209) of the magnetic layer, by moving magnetic domain walls of the magnetic layer by a distance corresponding to the length of one magnetic domain toward the end portion (201) of the magnetic layer and storing the data read from the magnetic layer in a stack memory (350) connected to the read head; and
writing the data stored in the stack memory to the magnetic layer using the write head (WH) provided at the end portion (201) of the magnetic layer and a current controller (300) connected to the write head and the stack memory by moving the magnetic domain walls of the magnetic layer by a distance corresponding to the length of one magnetic domain toward the other end portion (209) of the magnetic layer.

## Patentansprüche

1. Datenspeichervorrichtung mit magnetischer Domänenwandbewegung, wobei die Datenspeichervorrichtung umfasst:
eine Magnetschicht (200) mit einer Mehrzahl von magnetischen Domänen,
einen Schreibkopf (WH), der an einem Endabschnitt (201) der Magnetschicht vorgesehen ist,
einen Lesekopf (RH) zum Auslesen von Daten, die in die Magnetschicht eingeschrieben sind,
eine Stromsteuereinheit (300), die mit dem Schreibkopf und dem Lesekopf verbunden ist, und
eine Treibereinrichtung (400, 400a), die mit der Magnetschicht verbunden ist, wobei die Treibereinrichtung der Magnetschicht Strom zuführt,
um die Mehrzahl von magnetischen Domänen und Wände zwischen zwei benachbarten Domänen zu bewegen,
**dadurch gekennzeichnet, dass**
der Lesekopf an einem Abschnitt der Magnetschicht neben dem Schreibkopf vorgesehen ist,
die Mehrzahl von magnetischen Domänen sich weiter vom Lesekopf zu einem anderen Endabschnitt (209) der Magnetschicht erstreckt,
der Schreibkopf und der Lesekopf jeweils so vorgesehen sind, dass sie zugehörigen Bitbereichen zugeordnet sind, die nebeneinander- liegen,
und
sie weiter einen Stapelspeicher umfasst, der mit dem Lesekopf und der Stromsteuereinheit verbunden ist.

2. Datenspeichervorrichtung nach einem der vorhergehenden Ansprüche, wobei der Schreibkopf eine Struktur ist, bei der eine erste Elektrode (1), eine anti--ferromagnetische Schicht (2), eine ferromagnetische Schicht (3), eine Trennschicht (4), der Endabschnitt der Magnetschicht (201) und eine zweite Elektrode (5) sequentiell angeordnet sind.

3. Datenspeichervorrichtung nach Anspruch 2, weiter umfassend eine Trennschicht zwischen der Magnetschicht und dem Schreibkopf.

4. Datenspeichervorrichtung nach Anspruch 3, wobei die Trennschicht (4) eine Leiterschicht ist.

5. Datenspeichervorrichtung nach einem der vorhergehenden Ansprüche, wobei der Lesekopf (RH) eine Struktur ist, bei der eine erste Elektrode (6), eine anti-ferromagnetische Schicht (7), eine erste ferromagnetische Schicht (8), eine Trennschicht (9), eine zweite ferromagnetische Schicht (10) und eine zweite Elektrode (11) sequentiell abgeschieden sind.

6. Datenspeichervorrichtung nach einem der vorhergehenden Ansprüche, weiter umfassend eine Trennschicht (4) zwischen der Magnetschicht (209) und dem Lesekopf (RH).

7. Datenspeichervorrichtung nach Anspruch 6, wobei die Trennschicht zwischen der Magnetschicht (209) und dem Lesekopf (RH) eine Isolatorschicht oder eine Leiterschicht ist.

8. Datenspeichervorrichtung nach Anspruch 6, wobei die Trennschicht zwischen der Magnetschicht (209) und dem Lesekopf (RH) eine Leiterschicht ist und ein elektrischer Widerstand der Leiterschicht 10 bis 100 Mal höher ist als der der Magnetschicht.

9. Datenspeichervorrichtung nach einem der vorhergehenden Ansprüche, wobei die Magnetschicht eine lineare Magnetschicht ist.

10. Datenspeichervorrichtung nach einem der vorhergehenden Ansprüche, wobei eine Mehrzahl von Einkerbungen auf einer Seite der Magnetschicht ausgebildet ist.

11. Verfahren zum Betreiben einer Datenspeichervorrichtung, wobei das Verfahren umfasst:
Auslesen von Daten, die in eine Magnetschicht (200) mit einer Mehrzahl von magnetischen Domänen eingeschrieben sind, unter Verwendung eines Lesekopfs (RH), der an der Magnetschicht vorgesehen ist, wobei der Lesekopf an einem Abschnitt der Magnetschicht neben einem Schreibkopf (WH) an einem Endabschnitt (201) der Magnetschicht vorgesehen ist, wobei die Mehrzahl von magnetischen Domänen sich weiter vom Lesekopf zu einem anderen Endabschnitt (209) der Magnetschicht erstreckt, durch Bewegen magnetischer Domänenwände der Magnetschicht um eine Strecke, die der Länge einer magnetischen Domäne entspricht, zum Endabschnitt (201) der Magnetschicht und Speichern der aus der Magnetschicht ausgelesenen Daten in einem Stapelspeicher (350), der mit dem Lesekopf verbunden ist, und
Einschreiben der im Stapelspeicher gespeicherten Daten in die Magnetschicht unter Verwendung des am Endabschnitt (201) der Magnetschicht vorgesehenen Schreibkopfs (WH) und einer Stromsteuereinheit (300), die mit dem Schreibkopf und dem Stapelspeicher verbunden ist, durch Bewegen magnetischer Domänenwände der Magnetschicht um eine Strecke, die der Länge einer magnetischen Domäne entspricht, zum anderen Endabschnitt (209) der Magnetschicht.

## Revendications

1. Dispositif de stockage de données utilisant un mouvement de paroi de domaine magnétique, le dispositif de stockage de données comprenant :
une couche magnétique (200) ayant une pluralité de domaines magnétiques ;
une tête d'écriture (WH) prévue au niveau d'une partie d'extrémité (201) de la couche magnétique ;
une tête de lecture (RH) pour lire des données écrites sur la couche magnétique ;
un contrôleur de courant (300) connecté à la tête d'écriture et à la tête de lecture ; et
un dispositif de commande (400, 400a) connecté à la couche magnétique, le dispositif de commande délivrant du courant à la couche magnétique pour déplacer la pluralité de domaines et de parois magnétiques entre deux domaines magnétiques adjacentes ;
**caractérisé en ce que**
la tête de lecture est prévue au niveau d'une partie de la couche magnétique adjacente à la tête d'écriture ;
la pluralité de domaines magnétiques s'étendant en outre de la tête de lecture vers une autre partie d'extrémité (209) de la couche magnétique ;
la tête d'écriture et la tête de lecture sont prévues chacune de manière à correspondre à des zones de bits respectives qui sont adjacentes l'une à l'autre, et
comprenant en outre une mémoire de pile connectée à la tête de lecture et au contrôleur de courant.

2. Dispositif de stockage de données selon la revendication précédente, dans lequel la tête d'écriture est une structure dans laquelle une première électrode (1), une couche anti-ferromagnétique (2), une couche ferromagnétique (3), une couche de séparation (4), la partie d'extrémité de la couche magnétique (201) et une deuxième électrode (5) sont disposées séquentiellement.

3. Dispositif de stockage de données selon la revendication 2, comprenant en outre une couche de séparation entre la couche magnétique et la tête d'écriture.

4. Dispositif de stockage de données selon la revendication 3, dans lequel la couche de séparation (4) est une couche conductrice.

5. Dispositif de stockage de données selon l'une quelconque des revendications précédentes, dans lequel la tête de lecture (RH) est une structure dans laquelle une première électrode (6), une couche anti-ferromagnétique (7), une première couche ferromagnétique (8), une couche de séparation (9), une deuxième couche ferromagnétique (10) et une deuxième électrode (11) sont disposées séquentiellement.

6. Dispositif de stockage de données selon l'une quelconque des revendications précédentes, comprenant en outre une couche de séparation (4) entre la couche magnétique (209) et la tête de lecture (RH).

7. Dispositif de stockage de données selon la revendication 6, dans lequel la couche de séparation entre la couche magnétique (209) et la tête de lecture (RH) est une couche d'isolement ou une couche conductrice.

8. Dispositif de stockage de données selon la revendication 6, dans lequel la couche de séparation entre la couche magnétique (209) et la tête de lecture (RH) est une couche conductrice et une résistance électrique de la couche conductrice est 10 à 100 fois supérieure à celle de la couche magnétique.

9. Dispositif de stockage de données selon l'une quelconque des revendications précédentes, dans lequel la couche magnétique est une couche magnétique linéaire.

10. Dispositif de stockage de données selon l'une quelconque des revendications précédentes, dans lequel une pluralité d'encoches sont formées sur une surface de la couche magnétique.

11. Procédé de mise en oeuvre d'un dispositif de stockage de données, le procédé consistant à :
lire des données écrites sur une couche magnétique (200) ayant une pluralité de domaines magnétiques en utilisant une tête de lecture (RH) prévue au niveau de la couche magnétique, la tête de lecture étant prévue au niveau d'une partie de la couche magnétique adjacente à une tête d'écriture (WH) au niveau d'une partie d'extrémité (201) de la couche magnétique, la pluralité de domaines magnétiques s'étendant en outre de la tête de lecture vers une autre partie d'extrémité (209) de la couche magnétique, en déplaçant les parois de domaine magnétique de la couche magnétique d'une distance correspondant à la longueur d'un domaine magnétique vers la partie d'extrémité (201) de la couche magnétique, et stocker les données lues sur la couche magnétique dans une mémoire de pile (350) connectée à la tête de lecture ; et
écrire les données stockées dans la mémoire de pile sur la couche magnétique en utilisant la tête d'écriture (WH) prévue au niveau de la partie d'extrémité (201) de la couche magnétique et un contrôleur de courant (300) connecté à la tête d'écriture et à la mémoire de pile en déplaçant les parois de domaine magnétique de la couche magnétique d'une distance correspondant à la longueur d'un domaine magnétique vers l'autre partie d'extrémité (209) de la couche magnétique.
